# EUROPEAN PATENT APPLICATION

(11) **EP 4 425 578 A1**
(43) Date of publication of application: **04.09.2024**
(21) Application number: 24158758.3
(22) Date of filing: 21.02.2024
(51) Int. Cl.: H01L 31/05, H01L 31/18, H01L 31/048

(54) **METHOD OF MANUFACTURING SOLAR CELL STRING**

(30) Priority: 28.02.2023 JP 2023029968
(71) Applicant: Panasonic Holdings Corporation, Osaka 571-8501 (JP)
(72) Inventor: IRIKAWA, Junpei, Kadoma-shi, Osaka, 571-0057 (JP); HASHIMOTO, Haruhisa, Kadoma-shi, Osaka, 571-0057 (JP)
(74) Representative: Müller-Boré & Partner Patentanwälte PartG mbB

(57) **Abstract**

A method of manufacturing a solar cell string according to an embodiment of the present disclosure includes a pressure-bonding step in which a plurality of solar cells (20) which are provisionally fixed are pressurized using pressurizing members (121,122), so that the plurality of solar cells (20) are electrically connected to each other. In the pressure-bonding step, first sheet members (140) having a coefficient of friction of lower than or equal to 0.3 and a hardness of greater than or equal to D40, are placed above and below the solar cell, and the pressurizing members (121,122) are pressurized against the solar cell (20) with the first sheet members (140) therebetween.

## Description

### TECHNICAL FIELD

The present disclosure relates to a method of manufacturing a solar cell string formed by connecting a plurality of solar cells to a wiring member via an adhesive.

### BACKGROUND

In the related art, a solar cell module is known in which a solar cell string including a plurality of solar cells electrically connected to each other by a wiring member is sealed with a resin (refer to JP 5229497 B). JP 5229497 B discloses a method of manufacturing a solar cell string in which a connection step of the wiring member placed over the plurality of solar cells with the adhesive therebetween, and the resin sealing step, are collectively performed using a vacuum laminator.

By simultaneously performing the connection step of the wiring member placed over the plurality of solar cells, it is possible to shorten the manufacturing time. However, in the method of manufacturing the solar cell string of JP 5229497 B, because the connection step of the wiring member and the resin sealing step are collectively performed, the processes must be performed at a relatively low temperature (about 150°C), from the viewpoint of suppressing degradation of the resin. Because of this, there is a problem in that the thermal curing of the adhesive for adhering the solar cell and the wiring member requires a long period of time.

On the other hand, when the processes for the plurality of solar cells over which the wiring member is placed are to be simultaneously performed at a high temperature (greater than about 200°C and less than about 250°C), elongation of the wiring member due to the increase in the temperature tends to not be relaxed. As a result, there may be cases where stress is applied to the solar cell from the wiring member, and cracks occur in the solar cell. Thus, it is an important problem in the method of manufacturing the solar cell string, to suppress the cracks of the solar cell cell during pressure-bonding, while shortening the manufacturing time.

### SUMMARY

According to one aspect of the present disclosure, there is provided a method of manufacturing a solar cell string including: a pressure-bonding step in which a plurality of solar cells which are provisionally fixed are pressurized using a pressurizing member, to cause the plurality of solar cells to be electrically connected to each other, wherein, in the pressure-bonding step, first sheet members having a coefficient of friction of lower than or equal to 0.3 and a hardness of greater than or equal to D40, are placed above and below the solar cell, and the pressurizing member is pressurized against the solar cell with the first sheet member therebetween.

According to an aspect of the present disclosure, a method of manufacturing a solar cell cell string can be provided in which cracks of the solar cell during pressure-bonding can be suppressed while shortening the manufacturing time.

### BRIEF DESCRIPTION OF DRAWINGS

The figures depict one or more implementations in accordance with the present teachings, by way of example only, not by way of limitations. In the figures, like reference numerals refer to the same or similar elements. Embodiments of the present disclosure will be described based on the following figures, wherein:
FIG. 1 is a cross-sectional diagram of a solar cell module according to an embodiment of the present disclosure.
FIG. 2 is a plan view showing the solar cell according to the embodiment of the present disclosure, viewed from a first surface side.
FIG. 3 is a flowchart showing a method of manufacturing the solar cell string according to the embodiment of the present disclosure.
FIG. 4A is a diagram showing a provisional fixation step of the method of manufacturing the solar cell string according to the embodiment of the present disclosure.
FIG. 4B is a diagram showing the provisional fixation step of the method of manufacturing the solar cell string according to the embodiment of the present disclosure.
FIG. 4C is a diagram showing the provisional fixation step of the method of manufacturing the solar cell string according to the embodiment of the present disclosure.
FIG. 4D is a diagram showing the provisional fixation step of the method of manufacturing the solar cell string according to the embodiment of the present disclosure.
FIG. 4E is a diagram showing the provisional fixation step of the method of manufacturing the solar cell string according to the embodiment of the present disclosure.
FIG. 4F is a diagram showing the provisional fixation step of the method of manufacturing the solar cell string according to the embodiment of the present disclosure.
FIG. 5 is a diagram showing a pressure-bonding step of the method of manufacturing the solar cell string according to the embodiment of the present disclosure.
FIG. 6 is a perspective diagram schematically showing a pressure-bonding apparatus used in the pressure-bonding step of the method of manufacturing the solar cell string according to the embodiment of the present disclosure.
FIG. 7 is a cross-sectional diagram of a structure produced in a provisional fixation step of a method of manufacturing a solar cell string according to another configuration of the embodiment of the present disclosure.

### DESCRIPTION OF EMBODIMENTS

A solar cell module according to an embodiment of the present disclosure will now be described in detail with reference to the drawings. The drawings referred to in the embodiment are schematically described, and a size ratio of constituent elements drawn in the figures or the like should be determined in consideration of the following description.

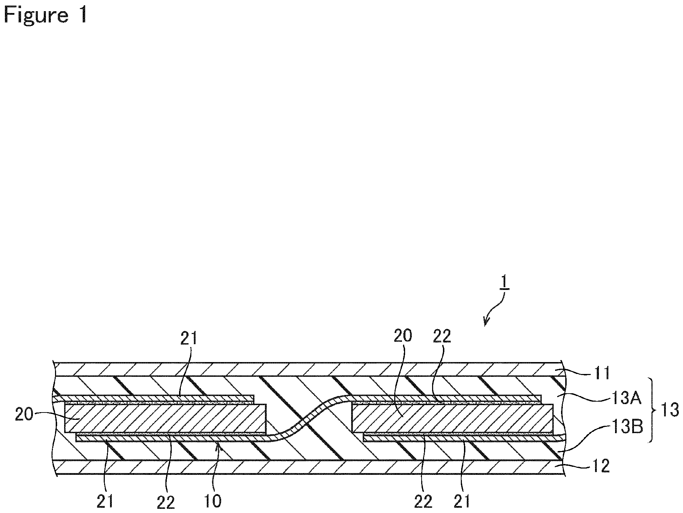

With reference to FIG. 1, a structure of a solar cell module 1 according to a first embodiment of the present disclosure will be described. FIG. 1 is a cross-sectional diagram of the solar cell module 1 according to the first embodiment.

As shown in FIG. 1, the solar cell module 1 includes a solar cell string 10 including a plurality of solar cells 20, a first protective member 11, and a second protective member 12. The first protective member 11 is provided on a side of a first surface of the solar cell string 10, and the second protective member 12 is provided on a side of a second surface of the solar cell string 10. In the present embodiment, the first surface serves as a light receiving surface, and the second surface serves as a back surface. The first protective member 11 is a member that protects the side of the first surface of the cell, and the second protective member 12 is a member that protects the side of the second surface of the cell. In addition, the solar cell module 1 includes a sealing layer 13 which is provided between the first protective member 11 and the second protective layer 12, and which seals the solar cell string 10.

The "light receiving surface" of the solar cell string 10 means a surface on which the light is primarily incident, and the "back surface" means a surface on an opposite side of the light receiving surface. Of the light incident on the solar cell string 10, more than 50% of the light, for example, greater than or equal to 80% or greater than or equal to 90% of the light is incident from the light receiving surface side.

As will be described later in detail, the solar cell string 10 includes a plurality of solar cells 20, a wiring member 21, and an adhesive 22. The solar cell string 10 is formed by connecting a plurality of solar cells 20, arranged along a direction of arrangement, to each other using the wiring member 21.

For the first protective member 11, for example, a glass substrate, a resin substrate, or the like which has a light transmissive property is employed. The first protective member 11 is in general flat, but may alternatively be curved. For the second protective member 12, a transparent member identical to the member for the first protective member 11 may be employed, or a non-transparent member may be employed. For the second protective member 12, for example, a resin sheet having a thinner thickness than the first protective member 11 may be employed.

The resin substrate applied for the first protective member 11 and the second protective member 12 is formed from, for example, at least one material selected from polyethylene (PE), polypropylene (PP), cyclic polyolefin, polycarbonate (PC), polymethylmethacrylate (PMMA), polytetrafluoroethylene (PTFE), polystyrene (PS), polyethylene terephthalate (PET), polyethylene naphthalate (PEN), polyvinyl fluoride (PVF), and polyvinylidene fluoride (PVDF).

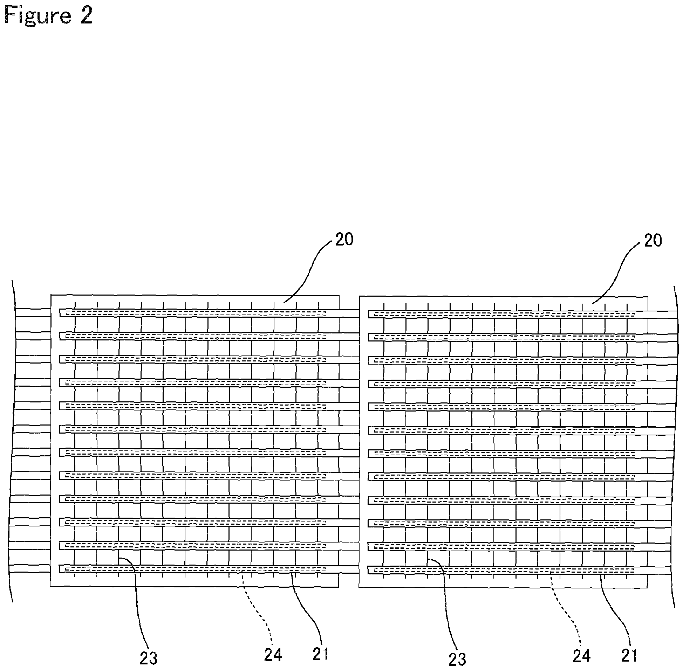

The sealing layer 13 is a resin layer which is provided between the first protective member 11 and the second protective layer 12, and which seals each solar cell 20. The sealing layer 13 closely contacts the solar cell 20 to restrict movement of the cell, and seals the solar cell 20 so that the solar cell 20 is not exposed to oxygen, water vapor, or the like. In the configuration exemplified in FIG. 2, the sealing layer 13 directly contacts each of the protective members and each of the solar cells 20. The solar cell module 1 has a layered structure in which the first protective member 11, the sealing layer 13, the solar cell string 10, the sealing layer 13, and the second protective member 12 are layered in this order from the side of the first surface. In the present embodiment, all of the solar cells 20 are sealed by the sealing layer 13, but alternatively, a structure may be employed in which, for example, a part of at least one solar cell 20 extends beyond the sealing layer 13. The sealing layer 13 is formed from a resin material such as, for example, polyolefin such as polyethylene or polypropylene, a copolymer of ethylene vinyl acetate (EVA), polyvinyl butyral (PVB), polyimide, polyethylene terephthalate (PET), or the like.

The sealing layer 13 is formed from a first sealing layer 13A provided between the first protective member 11 and the solar cell 20, and a second sealing layer 13B provided between the second protective member 12 and the solar cell 20. The sealing layer 13 is desirably formed through a laminating process that will be described later, using a resin member forming the first sealing layer 13A, and a resin member forming the second sealing layer 13B. For the first sealing layer 13A and the second sealing layer 13B, the same resin member may be employed, or different resin members may be employed. When the compositions of the resin members are the same, it may not be possible to recognize the interface between the sealing layers.

Next, with further reference to FIG. 2, the structure of the solar cell string 10 according to the present embodiment will be described. FIG. 2 is a plan view of the solar cell 20 forming the solar cell string 10 of FIG. 1, viewed from the side of the first surface.

As described above, the solar cell string 10 includes the plurality of solar cells 20, the wiring member 21, and the adhesive 22. The solar cell string 10 is formed by connecting the plurality of solar cells 20, arranged along the direction of arrangement, to each other using the wiring member 21.

The solar cell 20 includes a photovoltaic unit which generates carriers by receiving solar light, and a current collector electrode which is provided over the photovoltaic unit and which collects the carriers.

An example of the photovoltaic unit is a structure including a semiconductor substrate such as crystalline silicon (Si), gallium arsenide (GaAs), indium phosphide (InP), and the like, an amorphous semiconductor layer formed over the semiconductor substrate, and a transparent conductive layer formed over the amorphous semiconductor layer. More specifically, a structure may be exemplified in which an i-type amorphous silicon layer, a p-type amorphous silicon layer, and a transparent conductive layer are formed in this order over one surface of an n-type monocrystalline silicon substrate, and an i-type amorphous silicon layer, an n-type amorphous silicon layer, and a transparent conductive layer are formed in this order over the other surface of the substrate.

The current collector electrode is formed from a first surface electrode (light receiving surface electrode) formed over a first surface of the photovoltaic unit, and a second surface electrode (back surface electrode) formed over a second surface of the photovoltaic unit. In this case, one of the first surface electrode and the second surface electrode serves as an n-side electrode, and the other serves as a p-side electrode.

As shown in FIG. 2, the current collector electrode desirably includes a plurality of finger electrodes 23. However, for the second surface electrode, an electrode may be employed which covers approximately the entire region of the second surface of the photovoltaic unit. The plurality of finger electrodes 23 are electrodes of narrow line shape, formed approximately parallel with each other.

The current collector electrode may include a bus bar electrode 24 having a wider width than the finger electrode 23 and which is approximately orthogonal to each finger electrode. The wiring member 21 is attached to the bus bar electrode 24. The current collector electrode has a structure in which, for example, a conductive filler such as silver (Ag) is dispersed in a binder resin. The current collector electrode having this structure may be formed, for example, through screen printing. The structure of the photovoltaic unit may be, as an alternative to the hetero-junction type structure described above, TOPCON-type (Tunnel Oxide Passivated Contact cell), PERC-type (Passivated Emitter and Rear Cell), or IBC-type (Interdigitated Back Contact), and the polarity of the semiconductor substrate and the first surface is not limited to the n type. The current collector electrode may be formed, as an alternative to Ag, from metal having aluminum (Al), copper (Cu), or the like as a primary composition. Further, the back surface electrode may be an electrode which covers approximately the entire region of the back surface side of the solar cell 20.

The wiring member 21 is, for example, a line member having a cross section in a radial direction of an approximate true circle shape, and is formed with metal such as Al and Cu as a primary composition. The wiring member 21 may include a plating layer having, as a primary composition, Ag, nickel (Ni), or a low melting point metal used as solder. For example, a diameter of the wiring member 21 is greater than or equal to 0.2 mm and less than or equal to 0.4 mm. Desirably, a plurality of the wiring members 21 are attached to the first surface and the second surface of the solar cell 20. In the present embodiment, 12 wiring members 21 are provided, but the number of the wiring members 21 is not limited to this number, and may be less than 12 or greater than or equal to 13. Further, the cross-sectional shape of the wiring member 21 is not limited to the approximate true circle shape, and may alternatively be an approximate rectangular shape. When the cross-sectional shape of the wiring member 21 is the approximate rectangular shape, a thickness of the wiring member 21 is, for example, greater than or equal to 0.2 mm and less than or equal to 0.3 mm, and a width of the wiring member 21 is, for example, greater than or equal to 0.6 mm and less than or equal to 2.0 mm.

The wiring member 21 is placed along a longitudinal direction of the solar cell string 10, and is provided from a one-side end of one solar cell 20 among adjacent solar cells 20 to the other-side end of the other solar cell 20. A length of the wiring member 21 is slightly shorter than a length obtained by adding the lengths of two solar cells 20 and an inter-cell distance. The wiring member 21 is bent in a thickness direction of the module between adjacent solar cells 20, and is joined to the first surface of the one solar cell 20 and the second surface of the other solar cell 20, respectively, using the adhesive 22 that will be described below. The wiring member 21 is electrically connected to the current collector electrodes of the solar cells 20. In FIG. 2, a case is illustrated in which 12 wiring members 21 are connected to 12 bus bar electrode 24.

The adhesive 22 is placed between the solar cell 20 and the wiring member 21. In other words, the wiring member 21 is joined to the solar cell 20 via the adhesive 22. The adhesive 22 is desirably a thermosetting adhesive. As the thermosetting adhesive, there may be exemplified, for example, a urea-based adhesive, a resorcinol-based adhesive, a melamine-based adhesive, a phenol-based adhesive, an epoxy-based adhesive, a polyurethane-based adhesive, a polyester-based adhesive, a polyimide-based adhesive, and an acryl-based adhesive.

A curing temperature of the adhesive 22 is desirably lower than or equal to 220°C, and is more desirably lower than or equal to 200°C. The adhesive 22 before being cured is in a liquid form. Here, the "liquid form" refers to a state having fluidity at 30°C, and is intended to include a state called a paste form.

A viscosity of the adhesive 22 before being cured is desirably greater than or equal to 50 Pa·s, is more desirably greater than or equal to 75 Pa·s, and is further more desirably greater than or equal to 100 Pa·s. In this case, the wiring member 21 can be easily provisionally fixed over the solar cell 20 in the provisional fixation step which will be described later. The above-described viscosity is based on the standard, JIS K7117-2:1999, "Plastic -liquid, emulsion, or dispersive resin- measurement method of viscosity at constant shearing velocity by rotating circular clock", and is a value measured under conditions of a temperature of 30°C and a shearing velocity of 0.01/sec., and using a cone-plate rotating viscometer (having a mechanism radius of 24 mm and an angle of 1.34) (TV25 viscometer manufactured by Toki-Sangyo).

The adhesive 22 may contain a conductive filler such as Ag particles, but from the viewpoints of reduction of the manufacturing cost and reduction of light shielding loss, the use of non-conductive thermosetting adhesive which does not contain the conductive filler is desirable. When the non-conductive adhesive 22 is used, one or both of the wiring member 21 or the current collector electrode of the solar cell 20 is/are made uneven, and the insulative adhesive 22 is removed from the region between the wiring member 21 and the current collector electrode of the solar cell 20 so that the solar cell 20 and the wiring member 21 can be electrically connected to each other.

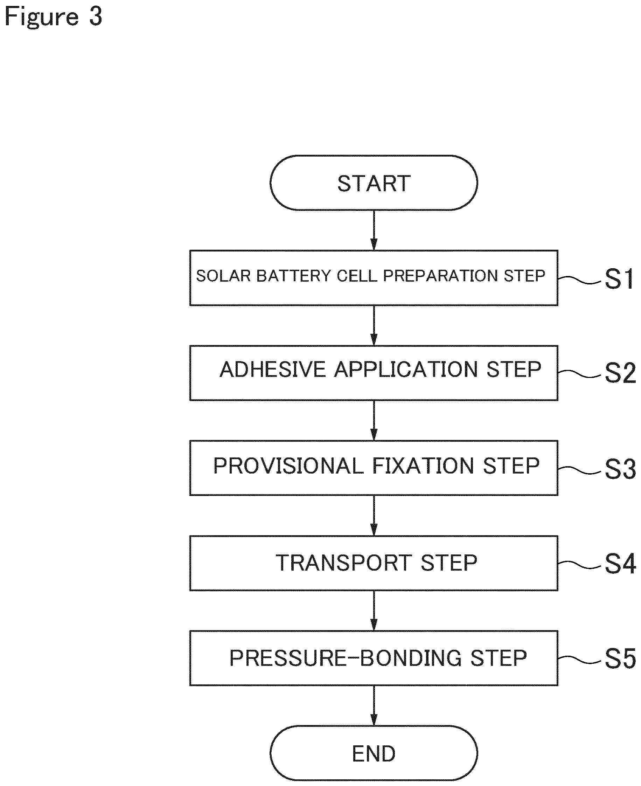

Next, a method of manufacturing the solar cell string 10 according to the present embodiment will be described with reference to FIGs. 3 to 5. FIG. 3 is a flowchart showing the method of manufacturing the solar cell string 10 according to the present embodiment.

As shown in FIG. 3, the manufacturing method according to the present embodiment includes a solar cell preparation step S1, an adhesive application step S2, a provisional fixation step S3, a transport step S4, and a pressure-bonding step S5.

The solar cell preparation step S1 is a step in which a plurality of solar cells 20 forming the solar cell string 10 are prepared. The adhesive application step S2 is a step in which the adhesive 22 (refer to FIG. 1) is applied over the first surface and the second surface of the solar cell 20 along an arrangement position of the wiring member 21.

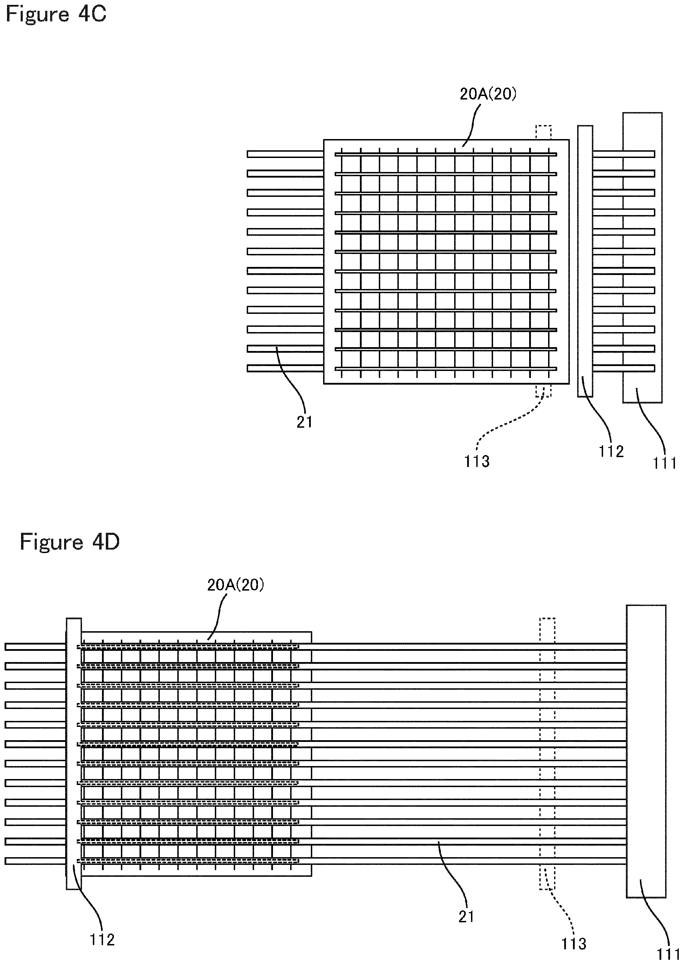

In the adhesive application step S2, the adhesive 22 may be applied alternately over the first surface and the second surface of the solar cell 20, or may be applied simultaneously over the first surface and the second surface. As the application method, screen printing, dispensing, or die-coating may be employed, or, alternatively, other methods may be employed. When the adhesive 22 is to be applied alternately over the first surface and the second surface, a table may be used which is inverted after application over one surface, and over which a groove is formed at a location corresponding to a portion to be printed. Further, patterns of the adhesive 22 applied over the first surface and the second surface of the solar cell 20 may be the same pattern for the first surface and the second surface, or may be different patterns. In addition, an amount of the adhesive 22 applied to a region which contacts a wiring member drawer 112 (refer to FIG. 4D) in the provisional fixation step S3 to be described later may be smaller than an amount of the adhesive 22 applied to other regions. With this configuration, it is possible to suppress contamination of the wiring member drawer 112 by the adhesive 22.

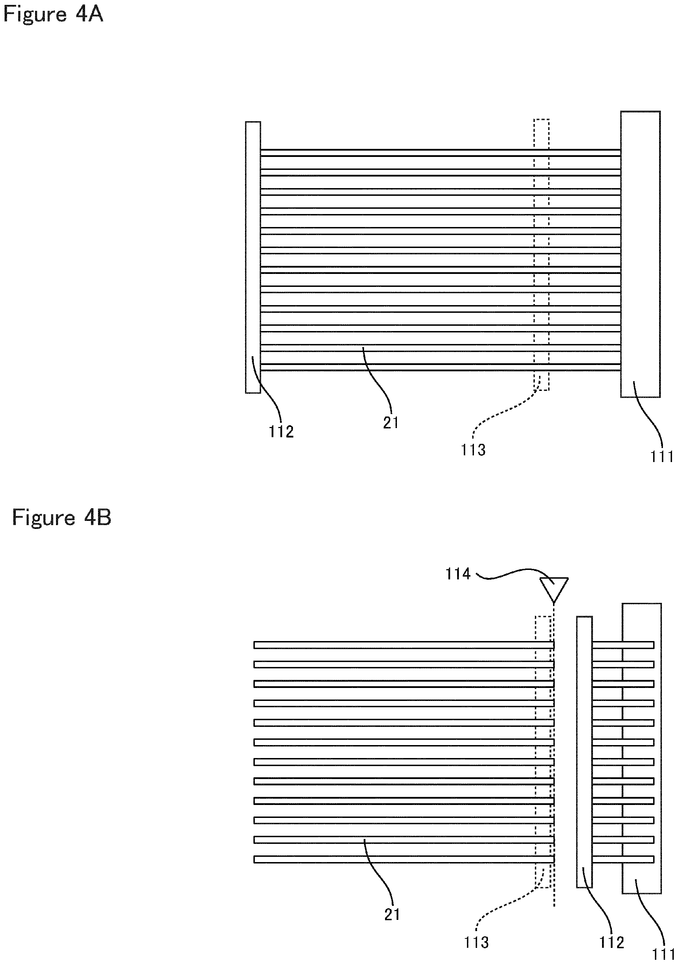

Next, the provisional fixation step S3 will be described in detail with reference to FIGs. 4A to 4F. FIGs. 4A to 4F are diagrams showing the provisional fixation step S3, and are plan views of the solar cell 20 viewed from the side of the first surface. The provisional fixation step S3 is a step in which the wiring member 21 is provisionally fixed over the first surface and the second surface of the solar cell 20 with the adhesive 22 (refer to FIG. 1) therebetween. In the present disclosure, the "provisional fixation" refers to fixation to a degree to allow separation of adjacent solar cells 20. More specifically, the "provisional fixation" means a state in which, when the adjacent solar cells 20 are connected to each other with the adhesive therebetween, the adhesive 22 is not completely cured.

First, as shown in FIG. 4A, a predetermined length of the wiring member 21 is drawn out from a wiring member winding portion 111, in which the wiring member 21 is wound around a bobbin or the like, by the wiring member drawer 112. In this process, the wiring member drawer 112 applies a tension force in the length direction of the wiring member 21 to the wiring member 21, so that the curvature of the wiring member 21 can be straightened, and a straightness of the wiring member 21 can be improved. Next, the wiring member 21 drawn out by the wiring member drawer 112 is placed over a stage (not shown) having a transporting function, and is fixed on the stage by a wiring member fixer 113.

No particular limitation is imposed on a structure of the wiring member fixer 113 so long as the wiring member fixer 113 can fix the wiring member 21 on the stage. The wiring member fixer 113 may be, for example, a suction hole which is provided on the stage and which sucks outside air.

Next, as shown in FIG. 4B, the wiring member drawer 112 is separated from the wiring member 21, and is moved to a predetermined position, and the wiring member 21 is held. Then, the wiring member 21 is cut into a predetermined length by a wiring member cutter 114. With this process, the wiring member 21 having the predetermined length is placed on the stage in a fixed state.

Next, as shown in FIG. 4C, a solar cell 20A is placed over the wiring member 21 fixed on the stage. In this process, the solar cell 20A is placed such that the adhesive 22 applied over the second surface of the solar cell 20A overlaps the wiring member 21 fixed on the stage. With this process, the current collector electrode formed over the second surface of the solar cell 20A and the wiring member 21 are provisionally fixed with respect to each other with the adhesive 22 therebetween.

When the solar cell 20A is placed over the wiring member 21, the solar cell 20A may be pressurized from the side of the first surface of the solar cell 20A, to press the second surface of the solar cell 20A against the wiring member 21. With this configuration, the wiring member 21 is more firmly provisionally fixed to the second surface of the solar cell 20A, and misalignment and dropping-off of the wiring member 21 can be suppressed.

Next, as shown in FIG. 4D, the solar cell 20A is moved to the left of FIG. 4D by a distance corresponding to one cell, and then, a predetermined length of the wiring member 21 is drawn out from the wiring member winding portion 111 by the wiring member drawer 112, and the winding member drawer 112 is moved to a predetermined position. The wiring member 21 is fixed on the stage by the wiring member fixer 113, and then, the wiring member 21 is pressed against the side of the first surface of the solar cell 20. With this process, the current collector electrode formed over the first surface of the solar cell 20A and the wiring member 21 are provisionally fixed to each other with the adhesive 22 therebetween.

A pressure when the wiring member 21 is pressed against the first surface of the solar cell 20A is desirably greater than or equal to 10 Pa. In this case, the wiring member 21 is more firmly provisionally fixed to the first surface of the solar cell 20A, and the misalignment and dropping-off of the wiring member 21 can be suppressed. Further, when the wiring member 21 is pressed against the first surface of the solar cell 20A, the wiring member drawer 112 may press the side of the first surface of the solar cell 20A while applying a tension force to the wiring member 21 in the length direction of the wiring member 21. With this process, the curvature of the wiring member 21 can be further straightened, and the straightness of the wiring member 21 can be further improved. After the wiring member 21 is provisionally fixed to the first surface of the solar cell 20A, the wiring member 21 is separated from the wiring member drawer 112.

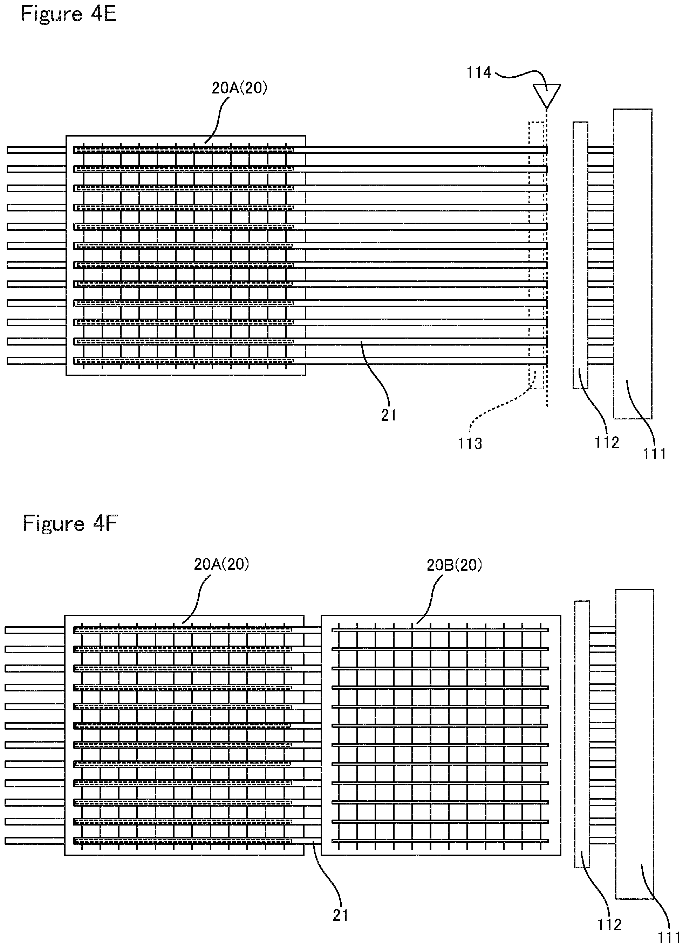

Next, as shown in FIG. 4E, the wiring member drawer 112 is separated from the wiring member 21, and is moved to a predetermined position, and the wiring member 21 is held. Then, the wiring member 21 is cut into a predetermined length by the wiring member cutter 114.

Then, as shown in FIG. 4F, another solar cell 20B is placed in a region, of the wiring member 21 fixed on the stage, where the wiring member 21 is not provisionally fixed to the solar cell 20A. In this process, the solar cell 20B is placed such that the adhesive 22 applied over the second surface of the solar cell 20B overlaps the wiring member 21 fixed on the stage. With this process, the current collector electrode formed over the second surface of the solar cell 20B and the wiring member 21 are provisionally fixed to each other with the adhesive 22 therebetween.

Alternatively, the position of the wiring member 21 may be adjusted before and after the placement of the solar cell 20B over the wiring member 21. As a method of adjusting the position of the wiring member 21, for example, a method may be employed in which a mechanism is prepared which is made of a resin and in which a cutout is formed at an appropriate position corresponding to the wiring member 21, and the mechanism is slid in the length direction of the wiring member 21. With this process, the wiring member 21 on the stage is guided to the appropriate position.

Then, the stage is moved to the left direction in FIG. 4D after the current collector electrode formed over the second surface of the solar cell 20B and the wiring member 21 are provisionally fixed to each other, so that the solar cell 20B is moved to the position of the solar cell 20A before the movement. In this process, the position of the wiring member 21 may be adjusted in correspondence with the movement of the stage.

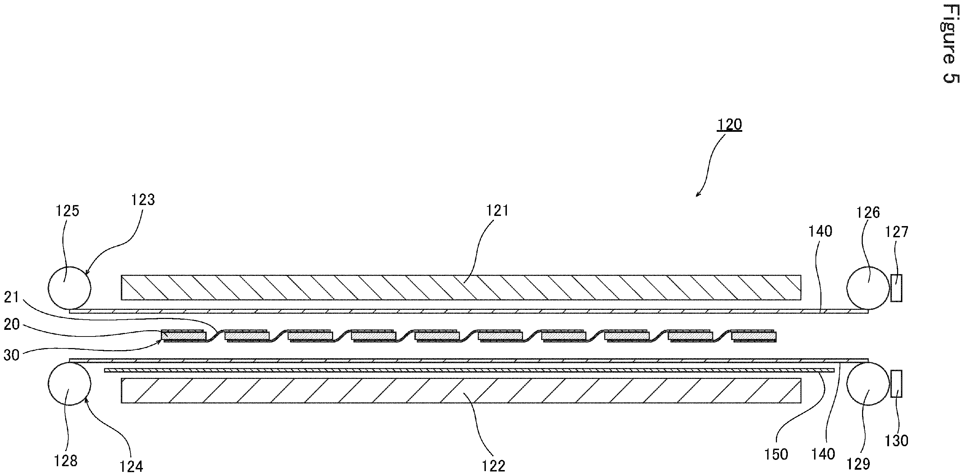

The steps described above and shown in FIGs. 4D to 4F are repeated a predetermined number of times, so that a structure 30 (refer to FIG. 5) can be produced in which a plurality of the solar cells 20 are provisionally fixed. In addition, as described above, in the provisional fixation step S3, the solar cell 20, the wiring member 21, and the adhesive 22 are not heated, and are processed at a temperature lower than or equal to 50°C, desirably, a temperature lower than or equal to 30°C. With this configuration, scattering of the resin or the like forming the adhesive 22 does not occur, and contamination of the manufacturing apparatus of the solar cell string 10 can be suppressed. In addition, even when the adhesive 22 is attached to the manufacturing apparatus due to operation defect or the like, because the heating process is not applied, the adhesive 22 does not solidify on the manufacturing apparatus, and can be easily wiped away.

The transport step S4 is a step in which the structure 30 produced in the provisional fixation step S3 is transported to a pressure-bonding apparatus 120 (refer to FIG. 5) used in the pressure-bonding step S5. In the present embodiment, the structure 30 is transported using a conveyer apparatus. In addition, in the transport step S4, the structure 30 is not pressurized or heated, and is transported at a temperature lower than or equal to 50°C, desirably, a temperature lower than or equal to 30°C. With this configuration, similar to the provisional fixation step S3, scattering of the resin or the like forming the adhesive 22 does not occur, and the contamination of the manufacturing apparatus of the solar cell string 10 can be suppressed. In addition, even when the adhesive 22 is attached to the manufacturing apparatus, because the heating process is not applied, the adhesive 22 does not solidify on the manufacturing apparatus, and can be easily wiped away. In the transport step S4, desirably, the structure 30 is transported in the length direction of the wiring member 21. With this configuration, the misalignment and the dropping-off of the wiring member 21 can be suppressed.

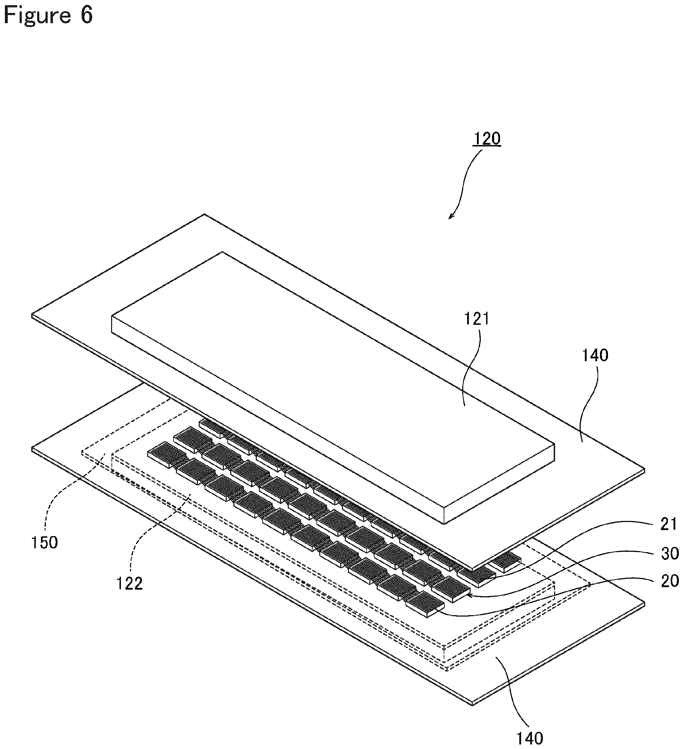

The pressure-bonding step S5 will now be described in detail with reference to FIGs. 5 and 6. FIG. 5 is a side view schematically showing the pressure-bonding apparatus 120 used in the pressure-bonding step S5, and FIG. 6 is a perspective diagram schematically showing the pressure-bonding apparatus 120. The pressure-bonding step S5 is a step in which the adhesive 22 (refer to FIG. 1) of the structure 30 is completely cured, to thereby adhere the current collector electrode of the solar cell 20 and the wiring member 21, and to consequently manufacture the solar cell string 10.

As shown in FIGs. 5 and 6, the pressure-bonding apparatus 120 used in the pressure-bonding step S5 includes an upper pressurizing member 121 provided on the side of the first surface of the solar cell 20, and a lower pressurizing member 122 provided on the side of the second surface of the solar cell 20. The pressure-bonding apparatus 120 further includes an upper sheet placement mechanism 123 provided on the side of the first surface of the solar cell 20, and a lower sheet placement mechanism 124 provided on the side of the second surface of the solar cell 20. In FIGs. 5 and 6, in order to show the structures more clearly, a region between the upper pressurizing member 121 and the lower pressurizing member 122 is shown with a larger spacing than the actual spacing. In addition, in FIG. 6, in order to show the structures more clearly, illustration of sheet rolls 125, 126, 128, and 129 that will be described later is omitted.

The upper pressurizing member 121 includes a heater built therein, and includes a mechanism which moves upward and downward. The upper pressurizing member 121 is pressurized with a predetermined pressure, so that the wiring member 21 is pressed against the solar cell 20. Then, the upper pressurizing member 121 is heated to a temperature greater than or equal to the curing temperature of the adhesive 22, so that the adhesive 22 is completely cured, and the solar cell 20 and the wiring member 21 are adhered to each other.

A pressure when the wiring member 21 is pressed against the solar cell 20 using the upper pressurizing member 121 is, for example, greater than or equal to 2000 Pa and less than or equal to 50000 Pa. Further, a temperature of the upper pressurizing member 121 during the pressurization is, for example, greater than or equal to 150°C and lower than or equal to 260°C.

Similar to the upper pressurizing member 121, the lower pressurizing member 122 may include a mechanism which moves upward and downward. The lower pressurizing member 122 may include a heater built therein, but in the present embodiment, the lower pressurizing member 122 does not include a built-in heater. When a heater is built into the lower pressurizing member 122, a temperature of the lower pressurizing member 122 during the pressurization is desirably lower than the temperature of the upper pressurizing member 121 during the pressurization.

Moreover, in the present embodiment, each of the upper pressurizing member 121 and the lower pressurizing member 122 is formed from one member, but alternatively, each of these members may be formed from a plurality of members. For example, each of the upper pressurizing member 121 and the lower pressurizing member 122 may be formed from the same number of members as the number of solar cells 20 forming the structure 30.

The upper sheet placement mechanism 123 is a mechanism which places a first sheet member 140 having a suitable slipperiness between the upper pressurizing member 121 and the first surface of the solar cell 20. The upper sheet placement mechanism 123 includes two sheet rolls 125 and 126. The two sheet rolls 125 and 126 repeat winding of the first sheet member 140 while placing the first sheet member 140 in a manner to cover the upper pressurizing member 121.

Desirably, a mechanism which removes contamination attached to the surface of the first sheet member 140 is provided on the upper sheet placement mechanism 123. In the present embodiment, a brush 127 is provided at an outer side of the sheet roll 126. With this configuration, when the first sheet member 140 is wound by the sheet roll 126, the brush 127 contacts the surface of the first sheet member 140, and the contamination on the surface of the first sheet member 140 is removed.

The lower sheet placement mechanism 124 is a mechanism which places the first sheet member 140 having suitable slipperiness between the lower pressurizing member 122 and the second surface of the solar cell 20. The lower sheet placement mechanism 124 includes two sheet rolls 128 and 129. The two sheet rolls 128 and 129 repeat winding of the first sheet member 140 while placing the first sheet member 140 in a manner to cover the lower pressurizing member 122.

Similar to the upper sheet placement mechanism 123, desirably, a mechanism which removes the contamination attached to the surface of the first sheet member 140 is provided on the lower sheet placement mechanism 124. In the present embodiment, a brush 130 for removing contamination on the surface of the first sheet member 140 is provided at an outer side of the sheet roll 129. With this configuration, when the first sheet member 140 is wound by the sheet roll 129, the brush 130 contacts the surface of the first sheet member 140, and the contamination on the surface of the first sheet member 140 is removed.

Here, a coefficient of kinetic friction of the first sheet member 140 is lower than or equal to 0.3, and the hardness of the first sheet member 140 is greater than or equal to D40. When the pressure-bonding is performed in a state where the structure 30 is sandwiched with the first sheet members 140 above and below the structure 30, the first sheet member 140 and the wiring member 21 suitably slip during the pressurization, and elongation of the wiring member 21 can be reduced. With this configuration, stress from the wiring member 21 to the solar cell 20 can be reduced, and occurrence of cracks of the solar cell 20 can be suppressed. The coefficient of kinetic friction described above is a value measured according to a method described in the standard, JIS K7125:1999, "Plastic -film and sheet- frictional coefficient testing method". In addition, the hardness described above is a value measured using a type-D durometer according to a method described in the standard, JIS K6253-3:2012.

The coefficient of kinetic friction of the first sheet member 140 is desirably lower than or equal to 0.25, is more desirably lower than or equal to 0.2, and is further desirably lower than or equal to 0.15. In this case, the elongation of the wiring member 21 during the pressure-bonding can be reduced, and the occurrence of the cracks of the solar cell 20 can be further suppressed. In addition, the hardness of the first sheet member 140 is desirably greater than or equal to D45, and is more desirably greater than or equal to D50.

A coefficient of thermal expansion of the first sheet member 140 is desirably lower than or equal to 5×10⁻⁵/K, is more desirably lower than or equal to 4×10⁻⁵/K, and is further desirably lower than or equal to 3×10⁻⁵/K. In this case, the elongation of the wiring member 21 during the pressure-bonding can further be reduced, and the occurrence of the cracks of the solar cell 20 can further be suppressed.

As the first sheet member 140, for example, a glass cloth coated with a fluororesin may be exemplified. As the fluororesin, for example, there may be exemplified polytetrafluoroethylene (PTFE), a copolymer of tetrafluoroethylene-hexafluoropropylene (FEP), and a copolymer of tetrafluoroethylene-fluoroalkylvinyl ether (PFA).

A thickness of the first sheet member 140 is desirably greater than or equal to 0.05 mm and less than or equal to 2.0 mm, and is more desirably greater than or equal to 0.1 mm and less than or equal to 1.0 mm. In this case, the elongation of the wiring member 21 during the pressure-bonding can be further reduced, and the occurrence of the cracks of the solar cell 20 can be further suppressed.

As shown in FIGs. 5 and 6, a second sheet member 150 having a cushioning property is placed between the lower sheet placement mechanism 124 and the lower pressurizing member 122. When the second sheet member 150 is placed, the second sheet member 150 compensates for the influence of unevenness of the solar cell 20 and the wiring member 21. With this configuration, the pressure during the pressurization can be made more uniform, and the misalignment of the wiring member 21 and the cracks of the solar cell 20 can be suppressed. A hardness of the second sheet member 150 is desirably less than D40, is more desirably less than or equal to D35, and is further desirably less than or equal to D30. No particular limitation is imposed on a coefficient of thermal expansion of the second sheet member 150, and, for example, the coefficient of thermal expansion of the second sheet member 150 may be larger than the coefficient of thermal expansion of the first sheet member 140.

As the second sheet member 150, for example, a silicone sheet or a silicone sponge may be exemplified.

A thickness of the second sheet member 150 is desirably greater than or equal to 0.01 mm and less than or equal to 20 mm, and is more desirable greater than or equal to 0.1 mm and less than or equal to 10 mm. In this case, the pressure during the pressurization can be made more uniform, and the suppression advantages of the misalignment of the wiring member 21 and the cracks of the solar cell 20 are more significant.

In the present embodiment, the second sheet member 150 is placed in the lower sheet placement mechanism 124, between the first sheet member 140 and the lower pressurizing member 122, but alternatively, the second sheet member 150 may be included in the lower sheet placement mechanism 124. That is, the lower sheet placement mechanism 124 may be a mechanism which places a sheet member, in which the first sheet member 140 and the second sheet member 150 are layered, between the lower pressurizing member 122 and the second surface of the solar cell 20. When the second sheet member 150 is included in the lower sheet placement mechanism 124, a gap is caused between the second sheet member 150 and the lower pressurizing member 122. With this configuration, it is possible to limit the time of contact between the second sheet member 150 and the lower pressurizing member 122 solely to the time of pressurization, and degradation of the second sheet member 150 due to heat can be suppressed. Alternatively, another sheet placement mechanism may be provided between the lower sheet placement mechanism 124 and the lower pressurizing member 122, and the second sheet member 150 may be placed between the lower sheet placement mechanism 124 and the lower pressurizing member 122 using this sheet placement mechanism. In this case, a gap is caused between the second sheet member 150, and the first sheet member 140 and the lower pressurizing member 122.

The pressure-bonding apparatus 120 desirably includes a mechanism which prevents sticking between the first sheet member 140 and the solar cell string 10 (refer to FIG. 1) after the pressure bonding. As the mechanism for preventing the sticking, for example, a function for temporarily loosening the first sheet member 140 may be provided on the upper sheet placement mechanism 123 or the lower sheet placement mechanism 124. Alternatively, for example, a pin which can move upward and downward, and which pushes the first sheet member 140 upward after the pressure bonding, may be provided on the upper sheet placement mechanism 123 or the lower sheet placement mechanism 124.

Further, the pressure-bonding apparatus 120 may include a mechanism which detects positions of the structure 30 and the solar cell string 10 before and after the pressure bonding. With this structure, an amount of misalignment before and after the pressure bonding can be identified. As a method of detecting the positions of the structure 30 and the solar cell string 10, there may be exemplified, for example, a method of detecting, using an optical sensor, a position of an alignment mark provided on the structure 30 and the solar cell string 10. Further, the pressure-bonding apparatus 120 may include a mechanism which adjusts a position of the solar cell string 10 after the pressure bonding, and may include a mechanism which moves, using an arm or the like, the solar cell string 10 in a direction that is different to the longitudinal direction of the solar cell string 10. Moreover, the lower sheet placement mechanism 124 may include a transport function of the solar cell string 10.

In addition, in the provisional fixation step S3, a plurality of the structures may be provisionally fixed in parallel. In the transport step S4, a plurality of the structures 30 may be transported in parallel, and the transport step S4 may include a step in which the plurality of structures 30 are transported in a direction perpendicular to the length direction of the wiring member 21, on the same plane as the structure 30. Further, in the pressure-bonding step S5, a plurality of the structures 30 may be simultaneously pressure-bonded, and FIG. 6 shows a case in which four structures 30 are simultaneously pressure-bonded. From the viewpoint of improving the productivity, when Y structures 30 each including X solar cells 20 are to be simultaneously pressure-bonded in the pressure-bonding step S5, if a tact time of the pressure-bonding step S5 is T1, a tact time of provisionally fixing the wiring member 21 over both surfaces of one solar cell 20 in the provisional fixation step S3 is T2, and a number of parallel provisional fixation is Z, it is desirable to satisfy a condition of T1/Y ≈ XxT2/Z. Here, it is desirable that the values on left and right sides are within ±20%, and is further desirable that the values are within ±10%. In addition, in the pressure-bonding step S5, the provisional fixation step S3 may be performed at the same time, to add the solar cell 20 and the wiring member 21 to an end of the structure 30 at any time, or a configuration may be employed in which a position at which the solar cell 20 and the wiring member 21 are added to the structure 30 changes within a certain range.

The solar cell module 1 can be manufactured by laminating the solar cell string 10, produced through the manufacturing method of the solar cell string 10 described above, and using resin sheets forming the first protective member 11, the second protective member 12, and the sealing layer 13. In a laminating apparatus, a first resin sheet which forms the first protective member 11 and the sealing layer 13, a second resin sheet which forms the solar cell string 10 and the sealing layer 13, and the second protective member 12, are layered in this order over a heater. This layered assembly is heated, for example, to a temperature at which the resin sheet forming the sealing layer 13 is softened in a vacuum state. Then, the heating is continued while pressing the constituting members toward the heater side under atmospheric pressure, to laminate the members, and the solar cell module 1 is finally obtained.

As described, the method of manufacturing the solar cell string 10 according to the present disclosure includes the pressure-bonding step S5 in which the structure 30, including a plurality of solar cells 20 which are provisionally fixed, is pressurized using the upper pressurizing member 121 and the lower pressurizing member 122, to electrically connect the plurality of solar cells 20 to each other. In the pressure-bonding step S5, the first sheet members 140 having a coefficient of friction of less than or equal to 0.3, and a hardness of greater than or equal to D40, are placed above and below the solar cell 20, and the upper pressurizing member 121 and the lower pressurizing member 122 are pressurized against the solar cell 20 with the first sheet members 140 therebetween. With this configuration, the first sheet member 140 and the wiring member suitably slip during the pressurization, and the elongation of the wiring member 21 is reduced. As a result, the stress by the wiring member 21 onto the solar cell 20 is reduced, and occurrence of cracks of the solar cell 20 can be suppressed.

Further, in the pressure-bonding step S5, desirably, the second sheet member 150 having a hardness of less than D40 is further placed above and/or below the solar cell 20. With this configuration, the pressure during the pressurization can be made more uniform, and the misalignment of the wiring member 21 and the cracks of the solar cell 20 are further suppressed.

The present disclosure is not limited to the embodiment described above, and various modifications and improvements are possible within the scope and spirit of the present disclosure described in the claims.

In the above-described embodiment, in the provisional fixation step S3, the solar cell 20, the wiring member 21, and the adhesive 22 are processed without being heated, and the solar cell 20 and the wiring member 21 are provisionally fixed to each other by the stickiness of the adhesive 22, but the present disclosure is not limited to such a configuration. For example, a configuration may be employed in which, in the provisional fixation step S3, after the wiring member 21 is placed over the current collector electrode of the solar cell 20 with the adhesive 22 therebetween, the solar cell 20 and the wiring member 21 may be heated to a temperature lower than the curing temperature of the adhesive 22, to provisionally fixe the current collector electrode and the wiring member 21. With this configuration, the current collector electrode and the wiring member 21 can be more firmly provisionally fixed to each other, and thus, the misalignment and dropping-off of the wiring member 21 during transport can be suppressed.

Further, in the above-described embodiment, in the structure 30 which is provisionally fixed, the first surface and the second surface, respectively, of adjacent solar cells 20 are connected by the wiring member 21, but the configuration of the structure 30 is not limited to such a configuration. For example, in the structure 30, the first surfaces of the adjacent solar cells 20 may be connected to each other, or the second surfaces of the adjacent solar cells 20 may be connected to each other. Alternatively, a configuration may be employed in which, while adjacent solar cells 20 are connected to each other by the wiring member 21, parts of the two adjacent solar cells overlap each other in the thickness direction.

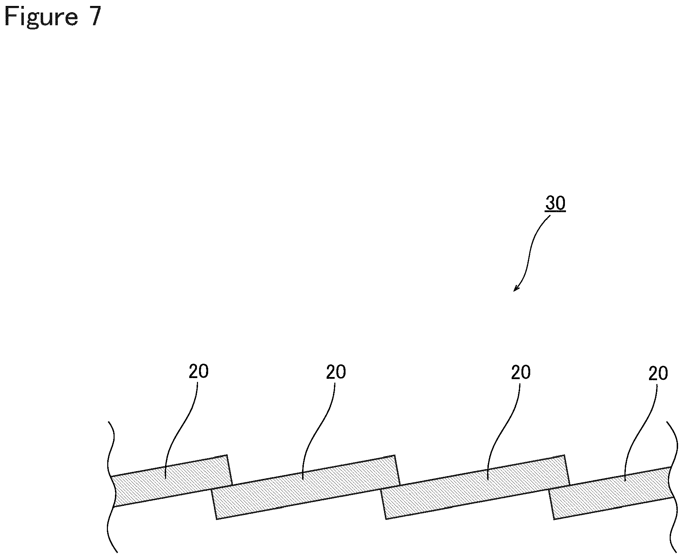

Moreover, in the above-described embodiment, in the structure 30 which is provisionally fixed, adjacent solar cells 20 are connected to each other by the wiring member 21, but the configuration of the structure 30 is not limited to such a configuration. For example, as shown in FIG. 7, the solar cell 20 forming the structure 30 may be placed, without the use of the wiring member, so that ends of the solar cells 20 overlap each other in the thickness direction of the solar cell 20 with a conductive or non-conductive adhesive or the like therebetween. In this case, when the structure 30 is pressure-bonded in the pressure-bonding step S5 of the present disclosure, the conductive adhesive provided in the region of overlap of the solar cells 20 is cured, and the solar cells 20 are electrically and physically connected to each other. When the structure 30 which uses the non-conductive adhesive is pressure-bonded, desirably, in the pressure-bonding step S5, a pressure of greater than or equal to 10000 Pa is applied to the region of overlap of the solar cells 20, to pressurize the solar cell 20.

While the foregoing has described what are considered to be the best mode and/or other examples, it is understood that various modifications may be made therein, and that the subject matter disclosed herein may be implemented in various forms and examples, and that they may be applied in numerous applications, only some of which have been described herein. It is intended by the following claims to claim any and all modifications and variations that fall within the true scope of the present teachings.

## Claims

1. A method of manufacturing a solar cell string (10) comprising:
a pressure-bonding step in which a plurality of solar cells (20) which are provisionally fixed are pressurized using a pressurizing member (121,122), to cause the plurality of the solar cells (20) to be electrically connected to each other, wherein
in the pressure-bonding step, first sheet members (140) having a coefficient of friction of lower than or equal to 0.3, and a hardness of greater than or equal to D40 are placed above and below the solar cell (20), and the pressurizing member (121,122) is pressurized against the solar cell (20) with the first sheet member (140) therebetween.

2. The method of manufacturing the solar cell string (10) according to claim 1, wherein
in the pressure-bonding step, a second sheet member (150) having a hardness of less than D40, and a coefficient of thermal expansion which is greater than a coefficient of thermal expansion of the first sheet member (140) is further placed above and/or below the solar cell (20), and the pressurizing member (121,122) is pressurized against the solar cell (20) with the first sheet member (140) and the second sheet member (150) therebetween.

3. The method of manufacturing the solar cell string (10) according to claim 1 or 2,
wherein
a coefficient of thermal expansion of the first sheet member (140) is lower than or equal to 5×10⁻⁵/K.

4. The method of manufacturing the solar cell string (10) according to any one of claims 1 to 3, wherein
the first sheet member (140) is a glass cloth coated with a fluororesin.

5. The method of manufacturing the solar cell string (10) according to claim 2, or according to claims 3 and/or 4 in combination with claim 2, wherein
the second sheet member (150) is a silicone sheet or a silicone sponge.

6. The method of manufacturing the solar cell string (10) according to any one of claims 1 to 5, wherein
the plurality of the solar cells (20) are provisionally fixed with an adhesive (22) therebetween, and
in the pressure-bonding step, the adhesive (22) is heated to a temperature greater than or equal to a curing temperature of the adhesive (22), so that the adhesive (22) is cured.

7. The method of manufacturing the solar cell string (10) according to any one of claims 1 to 6, wherein
in the pressure-bonding step, a temperature of the pressurizing member (121) placed above the solar cell (20) is higher than a temperature of the pressurizing member (121) placed below the solar cell (20).

8. The method of manufacturing the solar cell string (10) according to any one of claims 1 to 7, wherein
in the pressure-bonding step, a pressure of greater than or equal to 2000 Pa is applied to the solar cell (20) by the pressurizing member (121,122), to pressurize the solar cell (20).

9. The method of manufacturing the solar cell string (10) according to any one of claims 1 to 8, wherein
the plurality of the solar cells (20) are provisionally fixed in a state having regions overlapping in a thickness direction of the solar cell (20), and
in the pressure-bonding step, a pressure of greater than or equal to 10000 Pa is applied to the overlapping regions by the pressurizing member, to pressurize the solar cell (20).

10. The method of manufacturing the solar cell string (10) according to any one of claims 1 to 9, wherein
in the pressure-bonding step, a plurality of structures (30), in each of which a plurality of the solar cells (20) are provisionally fixed, are simultaneously pressurized.

11. The method of manufacturing the solar cell string (10) according to any one of claims 1 to 10, further comprising:
a provisional fixation step in which a wiring member (21) is placed over the solar cell (20) with an adhesive (22) therebetween, and the wiring member (21) and the solar cell (20) are provisionally fixed to each other, wherein
in the pressure-bonding step, a pressure of greater than or equal to 2000 Pa and lower than or equal to 50000 Pa is applied to the wiring member (21) by the pressurizing member (121,122), to pressurize the solar cell (20).

12. The method of manufacturing the solar cell string (10) according to claim 11, wherein
in the provisional fixation step, the adhesive (22) is heated to a temperature lower than a curing temperature of the adhesive (22), and the solar cell (20) and the wiring member (21) are provisionally fixed to each other.

13. The method of manufacturing the solar cell string (10) according to claim 11, wherein
in the provisional fixation step, the solar cell (20) and the wiring member (21) are provisionally fixed to each other by an stickiness of the adhesive (22) without heating the adhesive.
